Europäisches Patentamt

European Patent Office

Office européen des brevets

(19)

(11) EP 0 434 932 B1

(12) **EUROPÄISCHE PATENTSCHRIFT**

(45) Veröffentlichungstag und Bekanntmachung des Hinweises auf die Patenterteilung:
**10.01.1996 Patentblatt 1996/02**

(51) Int Cl.$^6$: **H05H 1/46**, H01J 37/32

(21) Anmeldenummer: **90120976.7**

(22) Anmeldetag: **02.11.1990**

(54) **Einrichtung für die Erzeugung eines Plasmas**

System for generating plasma

Dispositif de génération de plasma

(84) Benannte Vertragsstaaten:
**CH DE FR GB IT LI SE**

(30) Priorität: **23.12.1989 DE 3942964**

(43) Veröffentlichungstag der Anmeldung:
**03.07.1991 Patentblatt 1991/27**

(73) Patentinhaber:
**LEYBOLD AKTIENGESELLSCHAFT
D-63450 Hanau (DE)**

(72) Erfinder:
• **Gesche, Roland, Dr.
W-6453 Seligenstadt (DE)**

• **Kretschmer, Karl-Heinz, Dr.
W-6070 Langen (DE)**

(74) Vertreter: **Schickedanz, Willi, Dipl.-Ing.
D-63073 Offenbach (DE)**

(56) Entgegenhaltungen:
**WO-A-86/06923        US-A- 4 792 732**

• **PLASMA PHYSICS AND CONTROLLED FUSION, Band 26, Nr. 10, 1984, Seiten 1147-1162; R.W. BOSWELL: "Very efficient plasma generation by whistler waves near the lower hybrid frequency"**

**Beschreibung**

Die Erfindung betrifft eine Einrichtung für die Erzeugung eines Plasmas mittels zirkular polarisierter Hochfrequenzwellen.

Auf zahlreichen Gebieten der Technik ist es erforderlich, sehr dünne Materialschichten auf Träger aufzudampfen, um vorgegebene Eigenschaften zu erhalten. Beispiele hierfür sind die Interferenzfilter und die Compact-Disk-Scheiben. Um aus der Gasphase heraus aufdampfen zu können, müssen zuvor Gasplasmen erzeugt werden, d. h. Gase mit positiv und negativ geladenen sowie neutralen Teilchen.

Für die Herstellung solcher Plasmen sind zahlreiche Verfahren bekannt. Ein neuerdings weit verbreitetes Verfahren besteht darin, mit Hilfe von Mikrowellen und statischen Magnetfeldern eine Elektronen-Zyklotron-Resonanz zu erzeugen, wodurch eine starke Ionisierung von Gasen ermöglicht wird. Derartige Mikrowellen müssen mit Hohlleitern oder ähnlichen Wellenleitern eingespeist werden, da sie einen Frequenzbereich von 300 MHz bis 300 GHz bzw. einen Wellenlängenbereich von 1 m bis 1 mm umfassen. In diesem Bereich verhalten sich elektromagnetische Wellen quasi-optisch.

Es sind indessen auch Plasmaanregungen bekannt, bei denen elektromagnetische Wellen im UHF-Bereich bzw. im Bereich unterhalb 100 MHz verwendet werden (US-PS 4 691 662; Oechsner, Plasma Physics, Vol. 16, 1974, S. 835 bis 844; Boswell, Plasma Physics and Controlled Fusion, Vol. 26, Nr. 10, 1984, S. 1147 bis 1162). Treffen diese Wellen auf Magnetfelder, so breiten sie sich parallel zu diesen aus. In der Geophysik werden diese Wellen Whistler-Wellen genannt. Sie entstehen aus Blitzen und laufen den magnetischen Feldlinien entlang durch den Raum. In dem Gebiet, in dem diese Feldlinien die Erdoberfläche erreichen, hört man in einem Lautsprecher ein Pfeifen, das von hohen zu tiefen Tönen geht. In der Festkörperphysik werden die Whistler-Wellen auch Helicon-Wellen genannt (Harding und Thonemann, Study of helicon waves in indium, Proc. Phys. Soc. 1965, Vol. 85, S. 317 bis 328).

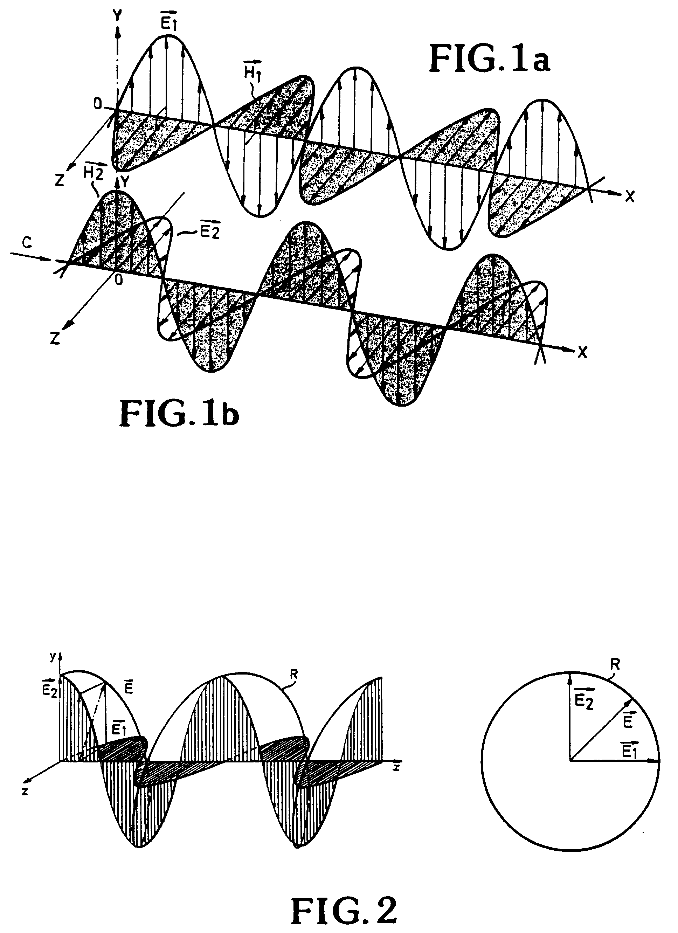

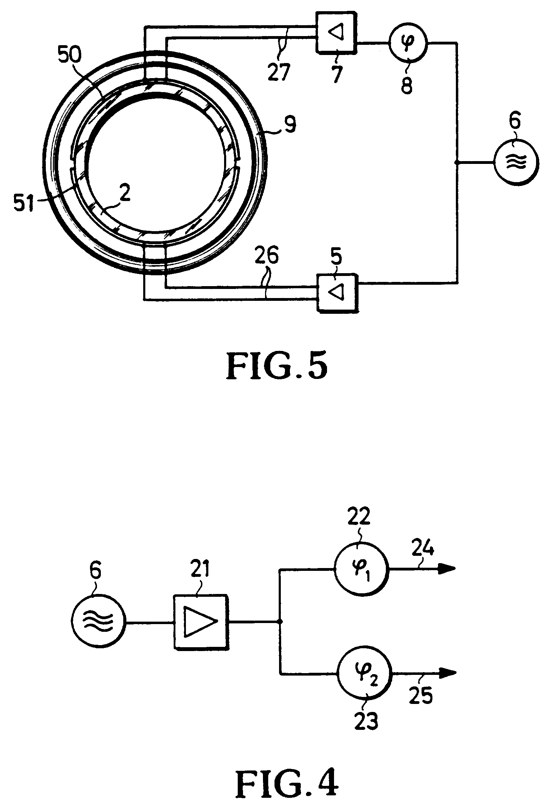

Um Whistler- oder Heliconwellen labormäßig zu erzeugen, müssen zunächst zirkular polarisierte Wellen erzeugt werden, denn bei den Whistler- und Heliconwellen handelt es sich um zirkular polarisierte Wellen. Hierzu ist es z. B. bekannt (Boswell, a.a.O, Fig. 4; Boswell, Perry und Emami, Le Vide, Les Couches Minces, Supplément au No. 246, März/April 1989, Fig. 1), eine 8,8 MHz-Schwingung von einem Oszillator und einem Verstärker auf ein Koaxialkabel zu geben, das über zwei variable Hochspannungskondensatoren in π-Schaltung an eine Antenne angepaßt wird. Nachteilig ist hierbei der Umstand, daß die spezielle Geometrie der Antenne eine leistungsmäßige Anpassung der Wellen an das Plasma erschwert und das Zündverhalten problematisch ist.

Auch bei einer anderen bekannten Anordnung, mit der zirkular polarisierte Wellen erzeugt werden können, ist es aufgrund der Antennengeometrie nicht möglich, eine leistungsmäßige Anpassung auf einfache Weise vorzunehmen (US-PS 4 160 978).

Es ist weiterhin ein Mikrowellen-Plasmagenerator bekannt, der jeweils senkrecht zueinander und um einen Behälter herum angeordnete Elektroden aufweist (US-A-4 792 732). Ein erstes Paar Elektroden liegt hierbei über einen 90°-Phasendreher an einer Spannung, während ein zweites Paar Elektroden direkt mit dieser Spannung verbunden ist, um ein zirkular polarisiertes Feld in dem Behälter zu erzeugen. Die Einspeisung der Energie erstreckt sich in Längsrichtung über die ganze Plasmakammer. Bei den eingestellten Feldern wird nur die Abhängigkeit im Querschnitt berücksichtigt. In Längsrichtung des Behälters wird Homogenität vorausgesetzt. Helicon-Wellen können hierdurch nicht angeregt werden, weil dies eine Anregung voraussetzt, die deutlich kürzer ist als die Wellenlänge. Da der bekannte Plasmagenerator mit Mikrowellen arbeitet, deren Wellenlängen sehr klein sind, ist diese Voraussetzung nicht erfüllt.

Der Erfindung liegt deshalb die Aufgabe zugrunde, eine Anordnung zu schaffen, mit der Whistler- oder Helicon-Wellen erzeugt werden können, wobei eine Anpassung dieser Wellen an verschiedene Impedanzen möglich ist.

Diese Aufgabe wird gemäß den Merkmalen der Patentansprüche 1 und 2 gelöst.

Der mit der Erfindung erzielte Vorteil besteht insbesondere darin, daß Helicon-Wellen und damit Plasmen mit hohem Wirkungsgrad erzeugt werden können. Da bei den verwendeten Hochfrequenzen die Wellenlänge im Bereich von einigen Zentimetern liegt, kann eine Anregung realisiert werden, die deutlich kürzer ist als die Wellenlänge. Mit einer Einkopplung der Wellen an mindestens zwei Stellen der Plasmaröhre kann bei entsprechender Phasenlänge eine Wellenlänge eingeprägt und damit die Plasmadichte beeinflußt werden. Bei Helicon-Wellen ist die Plasmadichte nämlich von der Wellenlänge abhängig. Ein weiterer Vorteil der Erfindung besteht darin, daß die Wellenlänge durch Verschieben der Einkopplung oder durch elektrisches Ändern der Phasenlage variabel ist, und zwar auch während des Betriebs.

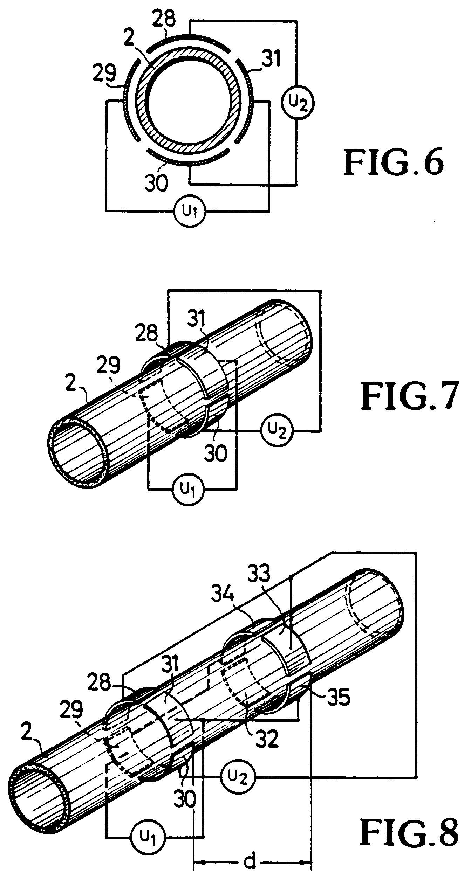

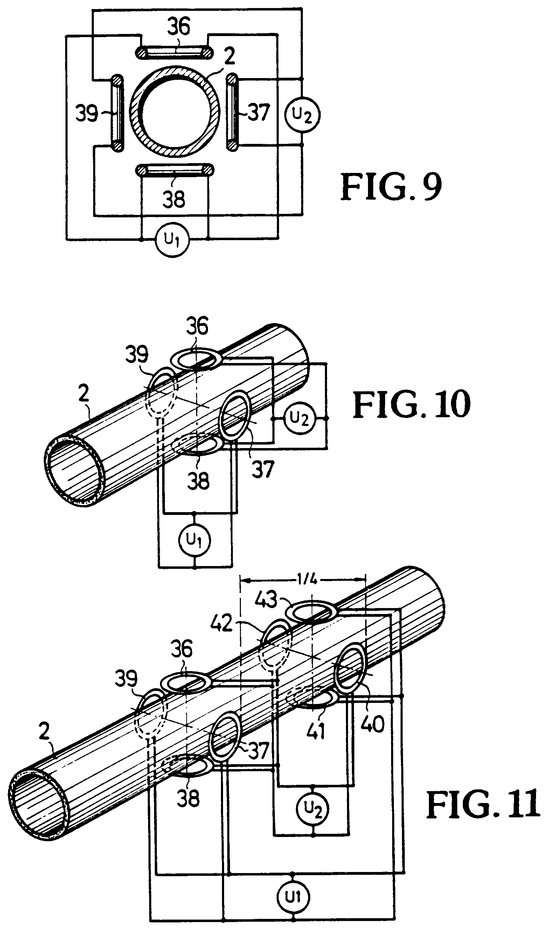

Ausführungsbeispiele der Erfindung sind in den Figuren 8 und 11 dargestellt. Es zeigen:

Fig. 1a      eine erste linear polarisierte Welle;

Fig. 1b      eine zweite linear polarisierte Welle;

Fig. 2      eine aus zwei linear polarisierten Wellen zusammengesetzte zirkular polarisierte Welle;

Fig. 3      eine Plasmakammer mit Zuführung von HF-Energie mittels zirkular polarisierten Wellen;

Fig. 4      eine Schaltung mit Phasenschiebern für die Erzeugung einer zirkular polarisierten Welle;

Fig. 5      eine Ansicht von oben auf die Plasmakammer gemäß Fig. 3;

Fig. 6      eine Anordnung für die kapazitive Einkopp-

Fig. 7 eine perspektivische Darstellung der Anordnung gemäß Fig. 6;

Fig. 8 eine Ausführungsform der Erfindung mit zwei Anordnungen gemäß Fig. 7, jedoch mit kapazitiven Einspeisungen, die einen Abstand d voneinander haben;

Fig. 9 eine Anordnung mit induktiver Einspeisung der elektromagnetischen Energie in das Plasma;

Fig. 10 eine perspektivische Darstellung der Anordnung gemäß Fig. 9;

Fig. 11 eine Ausführungsform der Erfindung mit zwei Anordnungen gemäß Fig. 10, die um λ/4 relativ zueinander versetzt sind.

In der Fig. 1a ist eine ebene, linear polarisierte elektromagnetische Welle dargestellt, die sich entlang der x-Achse bewegt, d.h. nach rechts fortpflanzt. Diese Welle besteht aus einem elektrischen Wechselfeld $\vec{E}_1$, das in y-Richtung zeigt, sowie aus einem magnetischen Wechselfeld $\vec{H}_1$, das in z-Richtung zeigt. Die Welle heißt eben, weil $\vec{E}_1$ und $\vec{H}_1$ unabhängig von y und z sind, sich also in den Ebenen x = constant örtlich nicht ändern. Sie wird als linear polarisiert bezeichnet, weil sich die Spitzen der Feldvektoren an einem festen Ort zeitlich auf einer geraden Linie bewegen.

Die Fig. 1b zeigt eine ähnliche Welle mit den Feldern $\vec{E}_2$ und $\vec{H}_2$ noch einmal, allerdings um 90 Grad phasenverschoben und um 90° in der Y-Z-Ebene gedreht.

Überlagert man die beiden Wellen gemäß Fig. 1a und Fig. 1b und betrachtet man nun die elektrischen Felder, so ergibt sich die Darstellung der Fig. 2, wobei allerdings die Drehrichtung des Gesamtfelds eine andere ist. Man erkennt hierbei, daß sich die Feld-Vektoren $\vec{E}_2$ und $\vec{E}_1$ zu einem Gesamtfeld $\vec{E}$ addieren. Wegen der 90°-Phasenverschiebung und der 90° Drehung in der Y-Z-Ebene beschreibt die Resultierende R eine Spirale. Diese Spirale ist in der Fig. 2 rechtsdrehend, während die Addition der Fig. 1a und 1b zu einer linksdrehenden Spirale führt. Aus der Sicht von der rechten Seite der x-Achse auf das Achsenkreuz der Fig. 2 ergibt sich somit eine Vektordarstellung, wie sie auf der rechten Seite der Fig. 2 gezeigt ist.

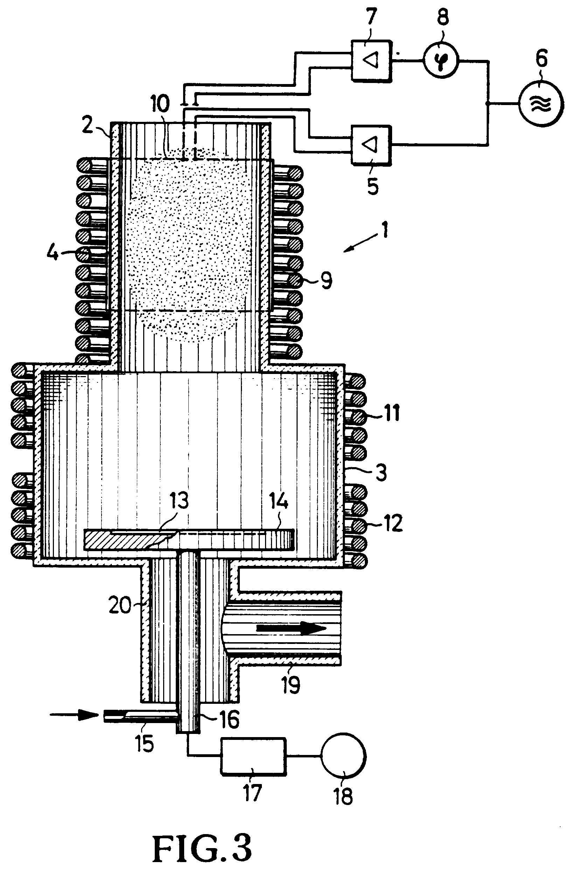

In der Fig. 3 ist eine Plasmakammer 1 dargestellt, die einen oberen Zylinder 2 und einen unteren Zylinder 3 enthält. Beide Zylinder 2, 3 bestehen beispielsweise aus Quarz und sind einstückig ausgebildet. Im oberen Zylinder 2, der von zwei Rahmenantennen umgeben ist, von denen man nur die Antenne 4 erkennt, wird Plasma ausgebildet. Die eine Rahmenantenne ist hierbei an einen Verstärker 7 angeschlossen, während die andere Rahmenantenne an einen Verstärker 5 angeschlossen ist.

Der Verstärker 5 ist direkt mit einem 13,56 MHz-Oszillator 6 verbunden. Dagegen liegt der Verstärker 7 über einen Phasenschieber 8 an diesem Ozillator 6. Mit Hilfe einer Solenoid-Spule 9 wird in dem Zylinder 2 ein statisches Mittelfeld erzeugt, welches die Ausbildung einer Whistler-Welle bewirkt. Die von den Rahmenantennen ausgehenden Hochfrequenzwellen werden also durch das Magnetfeld im Plasma 10 in den Whistler- oder Helicon-Zustand gekoppelt, wodurch der Transfer von Energie in das Zentrum des Plasmas gewährleistet wird.

Der Vorteil von Whistler- bzw. Helicon-Wellen besteht darin, daß sie mit den Bahnen der geladenen Teilchen des Plasmas 10 im Magnetfeld in Resonanz treten. Durch das Magnetfeld wird auch eine Einschnürung des Plasmas 10 bewirkt, die ihrerseits eine Zunahme der Dichte des Plasmas zur Folge hat. Das Plasma 10 diffundiert nun aus dem Zylinder 2 in den Zylinder 3 und wird dort durch weitere Solenoid-Spulen 10, 12 geführt. Ein Substrat 13, das sich auf einem Substrattisch 14 befindet, wird auf diese Weise durch das Plasma z. B. geätzt. Der Substrattisch 14 wird durch eine Wasserkühlvorrichtung 15, 16 gekühlt. An dieser Wasserkühlung 15, 16 ist über eine Anpassungsschaltung 17 eine Hochfrequenz 18 angeschlossen. Mit Hilfe einer nicht dargestellten Vakuumpumpe wird das Rest-Plasma, das nicht zum Ätzen des Substrats 13 genutzt werden konnte, über einen Stutzen 19 im unteren Bereich 20 der Plasmakammer 1 abgesaugt.

In der Fig. 4 ist eine Variante der in der Fig. 3 gezeigten Schaltungsanordnung für die Erzeugung einer zirkular polarisierten Welle dargestellt. Der 13,56-MHz-Oszillator 6 ist hierbei über einen Verstärker 21 sowohl mit einem ersten Phasenschieber 22 als auch mit einem zweiten Phasenschieber 23 verbunden. Die Ausgänge 24, 25 der beiden Phasenschieber 22, 23 stehen mit den Eingangsanschlüssen der in der Fig. 3 gezeigten Antenne 4 in Verbindung. Die Anordnung der Fig. 4 weist somit zwei Phasenschieber 22, 23 und einen Verstärker 21 auf, während die Anordnung der Fig. 3 einen Phasenschieber 8 und zwei Verstärker 5, 7 enthält.

In beiden Fällen dienen die Phasenschieber 8 bzw. 22, 23 dazu, zwei um 90° phasenverschobene HF-Spannungen zu erzeugen und über eine Antenne 4 einzuspeisen.

Die Fig. 5 zeigt eine Ansicht von oben auf den oberen Zylinder 2 der Plasmakammer. Man erkennt hierbei zwei Rahmenantennen 50, 51, von denen die Rahmenantenne 51 der Antenne 4 in Fig. 3 entspricht. Jede dieser Antennen 50, 51 ist über elektrische Leitungen 27, 26 an einen Verstärker 7, 5 angeschlossen.

In der Fig. 6 ist der obere Zylinder 2 der Plasmakammer 1 dargestellt, der von vier Elektroden 28 bis 31 umgeben ist. Hierbei ist eine erste Spannung $U_1$ an den sich gegenüberliegenden Elektroden 29, 31 und eine zweite Spannung $U_2$ an den sich gegenüberliegenden Elektroden 28, 30 angeschlossen. Beide Spannungen $U_1$, $U_2$

sind um 90° phasenverschoben, so daß sich eine zirkular polarisierte Welle ausbildet.

Die Fig. 7 zeigt die Anordnung der Fig. 6 noch einmal in perspektivischer Darstellung. Die vier Elektroden 28 bis 31 sind um jeweils ca. 90° versetzt, wobei an jeweils zwei gegenüberliegenden Elektroden je eine der um ca. 90° phasenverschobenen Spannungen $U_1$, $U_2$ angelegt ist.

In der Fig. 8, die eine erste Ausführungsform der Erfindung zeigt, sind mehrere Elektrodenkonfigurationen (28 bis 31, 32 bis 35) dargestellt, die einen Abstand voneinander haben und um eine Phasendifferenz versetzt gespeist werden.

Es wäre auch möglich, die Konfiguration 28 bis 31 auf dem Zylinder 2 relativ zur Konfiguration 32 bis 35 zu verdrehen. Der Abstand d zwischen den beiden Konfigurationen beträgt bei einer vorteilhaften Ausgestaltung etwa ein Viertel der effektiven Wellenlänge.

In der Fig. 9 ist eine induktive Einkopplung der elektromagnetischen Energie in das Plasma dargestellt. Hierfür sind vier Spulen 36 bis 39 vorgesehen, die an der Außenseite des Zylinders oder Rohrs 2 um jeweils ca. 90° versetzt angeordnet sind. An jeweils zwei gegenüberliegenden Spulen 37, 39 bzw. 36, 38 ist eine Spannung $U_1$ bzw. $U_2$ angelegt, wobei die eine Spannung $U_1$ gegenüber der anderen Spannung $U_2$ um 90° phasenverschoben ist.

In der Fig. 10 ist die Anordnung der Fig. 9 perspektivisch dargestellt. Alle Spulen 36 bis 39 liegen auf demselben Umfang des Zylinders 2. Es ist indessen auch möglich, die Spulen 37, 39 gegenüber den Spulen 36, 38 entlang der Achse des Zylinders 2 zu versetzen. Außerdem können sie um diese Achse relativ zueinander verdreht sein.

Die Fig. 11, die eine zweite Ausführungsform der Erfindung darstellt, zeigt zwei Spulenkonfigurationen 37 bis 39, 40 bis 43, die im Abstand von etwa einem Viertel der effektiven Wellenlänge auf dem Umfang des Zylinders 2 angeordnet sind. Die von diesen Konfigurationen 37 bis 39 bzw. 40 bis 43 erzeugten Felder weisen einen Phasenwinkel von ca. 90° zueinander auf.

**Patentansprüche**

1. Einrichtung für die Erzeugung eines Plasmas, das sich in einem Behälter befindet, mittels zirkular polarisierter Hochfrequenzwellen, wobei die Einkopplung der elektromagnetischen Energie in das Plasma durch die Wand des Behälters von außen über vier Elektroden erfolgt, die in einem ersten Bereich des Behälters angeordnet sind und von denen zwei erste Elektroden an einer ersten Spannung und zwei zweite Elektroden an einer zweiten Spannung liegen, wobei die erste Spannung gegenüber der zweiten Spannung eine Phasenverschiebung von 90° aufweist, **dadurch gekennzeichnet**, daß in einem Abstand (d) von den zwei ersten und zwei zweiten Elektroden (28 bis 31) zwei dritte und zwei vierte Elektroden (32 bis 35) angeordnet sind, die in derselben Weise wie die zwei ersten und zwei zweiten Elektroden (28 bis 31) an phasenverschobene Spannungen ($U_1$, $U_2$) gleicher Frequenz gelegt sind.

2. Einrichtung für die Erzeugung eines Plasmas, das sich in einem Behälter befindet, mittels zirkular polarisierten Hochfrequenzwellen, wobei die Einkopplung der elektromagnetishen Energie in das Plasma durch die Wand des Behälters von außen über Spulen erfolgt, die in einem ersten Bereich des Behälters angeordnet sind und von denen zwei erste Spulen an einer ersten Spannung und zwei zweite Spulen an einer zweiten Spannung liegen, wobei die erste Spannung gegenüber der zweiten Spannung eine Phasenverschiebung von 90° aufweist, und in einem Abstand (d) von den zwei ersten und zwei zweiten Spulen (36 bis 39) zwei dritte und zwei vierte Spulen (40 bis 43) angeordnet sind, die in derselben Weise wie die zwei ersten und zwei zweiten Spulen (36 bis 39) an phasenverschobene Spannungen ($U_1$, $U_2$) gleicher Frequenz gelegt sind.

3. Einrichtung nach Anspruch 1 oder 2, **dadurch gekennzeichnet**, daß die Hochfrequenzspannungsquelle durch einen Oszillator (6) realisiert ist, dessen Ausgangssignal einmal ohne Phasenverschiebung und einmal mit Phasenverschiebung dem Plasma zugeführt ist, wobei die Spannung des Oszillators (6) einmal über einen Verstärker (5) und einmal über einen Phasenverschieber (8) und einen Verstärker (7) dem Plasma zugeführt ist.

4. Einrichtung nach Anspruch 3, **dadurch gekennzeichnet**, daß die Spannung des Oszillators (6) über einen Verstärker (21) einem ersten Phasenschieber (22) und einem zweiten Phasenschieber (23) dem Plasma zugeführt ist.

5. Einrichtung nach Anspruch 1 oder 2, **dadurch gekennzeichnet**, daß zur Erzielung einer Phasendrehung von ca. 90° eine Leitung verwendet wird, deren Länge etwa einem Viertel der Wellenlänge der Hochfrequenzspannung ($U_1$, $U_2$) entspricht.

6. Einrichtung nach Anspruch 1 oder 2, **dadurch gekennzeichnet**, daß die zwei ersten zweiten Elektroden (28 bis 31) bzw. Spulen (36 bis 39) gegenüber den zwei dritten und vierten Elektroden (32 bis 35) bzw. Spulen (40 bis 43) um die Achse des Behälters (2) versetzt sind.

7. Einrichtung nach Anspruch 1 oder 2, **dadurch gekennzeichnet**, daß zusätzlich zu den Hochfrequenzwellen dem Plasma ein statisches oder niederfrequentes Magnetfeld zugeführt ist.

**8.** Einrichtung nach Anspruch 7, **dadurch gekennzeichnet**, daß das statische oder niederfrequente Magnetfeld mittels einer Spule (9) erzeugt wird, die den Behälter (2) umgibt.

**9.** Einrichtung nach Anspruch 1 oder 2, **dadurch gekennzeichnet**, daß an den Behälter (2), in dem sich das Plasma befindet, ein zweiter Behälter (3) anschließt, der mit dem ersten Behälter einstückig ausgebildet ist, und daß um den zweiten Behälter (3) eine Spule (11 bzw. 12) angeordnet ist.

**10.** Einrichtung nach einem oder mehreren der voran-gegangenen Ansprüche, **dadurch gekennzeich-net**, daß die Phasen der Hochfrequenzspannungen eine relative Drehung von 90° zueinander aufweisen.

**11.** Einrichtung nach Anspruch 1 oder 2, **dadurch gekennzeichnet**, daß der Abstand (d) und damit die Wellenlänge durch eine mechanische Verschiebung der Elektroden variabel ist.

**12.** Einrichtung nach Anspruch 1 oder 2, **dadurch gekennzeichnet**, daß die Wellenlänge durch elektrisches Ändern der Phasenlage variabel ist.

**Claims**

**1.** A device for generating a plasma contained in a container by means of circularly polarised high-frequency waves, where the input-coupling of the electromagnetic energy into the plasma takes place through the wall of the container from the exterior via four electrodes which are arranged in a first region of the container and of which two first electrodes are connected to a first voltage and two second electrodes are connected to a second voltage, where the first voltage exhibits a phase shift of 90° relative to the second voltage, characterised in that at a distance (d) from the two first and two second electrodes (28 to 31) are arranged two third and two fourth electrodes (32 to 35) which in the same way as the two first and two second electrodes (28 to 31) are connected to phase-shifted voltages ($U_1$, $U_2$) of the same frequency.

**2.** A device for the generation of a plasma contained in a container by means of circularly polarised high-frequency waves, where the input-coupling of the electromagnetic energy into the plasma takes place through the wall of the container from the exterior via coils which are arranged in a first region of the container and of which two first coils are connected to a first voltage and two second coils are connected to a second voltage, where the first voltage exhibits a phase shift of 90° relative to the second voltage and at a distance (d) from the two first and two second coils (36 to 39) are arranged two third and two fourth coils (40 to 43) which in the same way as the two first and two second coils (36 to 39) are connected to phase-shifted voltages ($U_1$, $U_2$) of the same frequency.

**3.** A device as claimed in Claim 1 or 2, characterised in that the high-frequency voltage source is formed by an oscillator (6), the output signal of which is fed to the plasma on the one hand with no phase shift and on the other hand with a phase shift, where the voltage of the oscillator (6) is fed to the plasma on the one hand via an amplifier (5) and on the other hand via a phase shifter (8) and an amplifier (7).

**4.** A device as claimed in Claim 3, characterised in that the voltage of the oscillator (6) is fed via an amplifier (21), a first phase shifter (22) and a second phase shifter (23) to the plasma.

**5.** A device as claimed in Claim 1 or 2, characterised in that in order to achieve a phase rotation of approximately 90° a line whose length corresponds approximately to one quarter of the wave length of the high-frequency voltage ($U_1$, $U_2$) is used.

**6.** A device as claimed in Claim 1 or 2, characterised in that the two first and second electrodes (28 to 31) or coils (36 to 39) are offset about the axis of the container (2) relative to the two third and fourth electrodes (32 to 35) or coils (40 to 43).

**7.** A device as claimed in Claim 1 or 2, characterised in that in addition to the high-frequency waves, a static or low-frequency magnetic field is supplied to the plasma.

**8.** A device as claimed in Claim 7, characterised in that the static or low-frequency magnetic field is generated by means of a coil (9) surrounding the container (2).

**9.** A device as claimed in Claim 1 or 2, characterised in that the container (2) in which the plasma is contained is adjoined by a second container (3) which is integrally formed with the first container (2) and that a coil (11 or 12) is arranged around the second container (3).

**10.** A device as claimed in one or more of the preceding claims, characterised in that the phases of the high-frequency voltages exhibit a relative rotation of 90° with respect to one another.

**11.** A device as claimed in Claim 1 or 2, characterised in that the distance (d) and thus the wave length is variable by mechanically displacing the electrodes.

12. A device as claimed in Claim 1 or 2, characterised in that the wave length is variable by electrically changing the phase position.

## Revendications

1. Dispositif destiné à produire un plasma, qui se trouve dans un récipient, au moyen d'ondés à haute fréquence polarisées de façon circulaire, dans lequel l'amenée de l'énergie électro-magnétique dans le plasma se produit à travers la paroi du récipient, depuis l'extérieur, par quatre électrodes, qui sont placées dans une première zone du récipient et dont deux premières électrodes sont soumises à une première tension et deux deuxièmes électrodes à une seconde tension, dans lequel la première tension présente un déphasage de 90° par rapport à la seconde tension, caractérisé en ce qu'à une distance (d) des deux premières et des deux deuxièmes électrodes (28 à 31), sont prévues deux troisièmes et deux quatrièmes électrodes (32 à 35), auxquelles s'appliquent comme aux deux premières et aux deux deuxièmes électrodes (28 à 31), des tensions déphasées ($U_1$, $U_2$) de même fréquence.

2. Dispositif destiné à produire un plasma, qui se trouve dans un récipient, au moyen d'ondes à haute fréquence polarisées de façon circulaire, dans lequel l'amenée de l'énergie électro-magnétique dans le plasma se produit à travers la paroi du récipient, depuis l'extérieur, par des bobines, qui sont placées dans une première zone du récipient et dont deux premières bobines sont soumises à une première tension et deux deuxièmes bobines à une seconde tension, dans lequel la première tension présente un déphasage de 90° par rapport à la seconde tension et dans lequel, à une distance (d) des deux premières et des deux deuxièmes bobines (36 à 39), sont prévues deux troisièmes et deux quatrièmes bobines (40 à 43), auxquelles s'appliquent comme aux deux premières et aux deux deuxièmes bobines (36 à 39), des tensions déphasées ($U_1$, $U_2$) de même fréquence.

3. Dispositif selon la revendication 1 ou 2, caractérisé en ce que la source de tension à haute fréquence est réalisée par un oscillateur (6) dont le signal de sortie est envoyé au plasma une fois sans déphasage et une fois avec déphasage, la tension de l'oscillateur (6) étant envoyée au plasma une fois par un amplificateur (5) et une fois par un déphaseur (8) et un amplificateur (7).

4. Dispositif selon la revendication 3, caractérisé en ce que la tension de l'oscillateur (6) est envoyée au plasma, par l'intermédiaire d'un amplificateur (21), à un premier déphaseur (22) et à un second déphaseur (23).

5. Dispositif selon la revendication 1 ou 2, caractérisé en ce que pour obtenir une rotation de phase d'environ 90°, on utilise une ligne dont la longueur correspond environ à un quart de la longueur d'onde de la tension à haute fréquence ($U_1$, $U_2$).

6. Dispositif selon la revendication 1 ou 2, caractérisé en ce que les deux premières et les deux deuxièmes électrodes (28 à 31) ou bobines (36 à 39) sont décalées par rapport aux deux troisièmes et aux deux quatrièmes électrodes (32 à 35) ou bobines (40 à 43), autour de l'axe du récipient (2).

7. Dispositif selon la revendication 1 ou 2, caractérisé en ce qu'en plus des ondes à haute fréquence il est envoyé au plasma un champ magnétique statique ou à basse fréquence.

8. Dispositif selon la revendication 7, caractérisé en ce que le champ magnétique statique ou à basse fréquence est produit au moyen d'une bobine (9) qui entoure le récipient (2).

9. Dispositif selon la revendication 1 ou 2, caractérisé en ce qu'au récipient (2) dans lequel se trouve le plasma est raccordé un deuxième récipient (3) qui est réalisé d'une seule pièce avec le premier récipient (2) et en ce qu'une bobine (11 ou 12) est placée autour du deuxième récipient (3).

10. Dispositif selon l'une ou plusieurs des revendications précédentes, caractérisé en ce que les phases des tensions à haute fréquence présentent un déphasage relatif de 90°.

11. Dispositif selon la revendication 1 ou 2, caractérisé en ce que la distance (d) et donc la longueur d'onde est rendue variable par une translation mécanique des électrodes.

12. Dispositif selon la revendication 1 ou 2, caractérisé en ce que la longueur d'onde est rendue variable par variation électrique du déphasage.

FIG.1a

FIG.1b

FIG.2

FIG.3

**FIG.5**

**FIG.4**

FIG.6

FIG.7

FIG.8

FIG. 9

FIG. 10

FIG. 11